# EUROPEAN PATENT APPLICATION

(11) **EP 4 629 288 A1**
(43) Date of publication of application: **08.10.2025**
(21) Application number: 25166642.6
(22) Date of filing: 27.03.2025
(51) Int. Cl.: H01L 23/495, H01L 23/498

(54) **SEMICONDUCTOR DEVICE INCLUDING A ROUTABLE HEAT SPREADER**

(30) Priority: 05.04.2024 US 202418627559
(71) Applicant: NXP USA, Inc., Austin, TX 78735 (US)
(72) Inventor: Singh, Akhilesh Kumar, 5656AG Eindhoven (NL); Sharma, Gaurav, 5656AG Eindhoven (NL); Shantaram, Sandeep, 5656AG Eindhoven (NL); Mathew, Varughese, 5656AG Eindhoven (NL)
(74) Representative: Colaiuda, Antonella

(57) **Abstract**

A semiconductor device may include a circuit substrate, a processor device, and a routable heat spreader (RHS). The circuit substrate may include a build-up portion formed from multiple layers including metal layers separated by dielectric layers and including interconnections between at least some of the metal layers. The circuit substrate may include multiple contact terminals including a first contact terminal and one or more second contact terminals. The processor device may include a first side and a second side. The processor device may be coupled to the first contact terminal on the first side. The RHS may be formed from a thermally conductive and electrically conductive material and may extend over the second side of the processor device. The RHS may include one or more conductive terminals electrically isolated from a remainder of the RHS and electrically coupled to one of the one or more second contact terminals.

## Description

### FIELD OF USE

The present disclosure generally relates to semiconductor devices including a heat spreader configured to dissipate heat, and more particularly, to semiconductor devices including an electrically routable heat spreader.

### BACKGROUND

Increasingly complex systems are driving trends toward incorporation of sophisticated semiconductor chips in devices that are used every day. Such semiconductor chips may include processors and logic circuitry, which can generate heat. Heat can sometimes degrade circuit performance.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1 depicts a diagram of a system including a semiconductor device that has a routable heat spreader, in accordance with some embodiments of the present disclosure.
FIG. 2A depicts a side view of a semiconductor device including a routable heat spreader, in accordance with some embodiments of the present disclosure.
FIG. 2B depicts a top view of an embodiment of the semiconductor device of FIG. 2A.
FIG. 3 depicts a cross-sectional view of an embodiment of a semiconductor device taken along line 3-3 in FIG. 2B and including a circuit coupled to a terminal of a routable heat spreader, in accordance with some embodiments of the present disclosure.
FIG. 4 depicts a cross-sectional view of another embodiment of a semiconductor device taken along line 3-3 in FIG. 2B and including a circuit coupled to a terminal of a routable heat spreader, in accordance with some embodiments of the present disclosure.
FIG. 5 depicts a cross-sectional view of another embodiment of a semiconductor device taken along line 3-3 in FIG. 2B and including a circuit coupled to a terminal of a routable heat spreader and including a through silicon via (TSV), in accordance with some embodiments of the present disclosure.
FIG. 6 depicts a cross-sectional view of another embodiment of a semiconductor device taken along line 3-3 in FIG. 2B and including a circuit coupled to a terminal of a routable heat spreader and including a conductive interposer, in accordance with some embodiments of the present disclosure.
FIG. 7 depicts a flow diagram of an embodiment of a method of forming a plurality of routable heat spreaders, in accordance with some embodiments of the present disclosure.
FIG. 8 depicts a flow diagram of an embodiment of a method of forming a plurality of routable heat spreaders, in accordance with some embodiments of the present disclosure.
FIG. 9 depicts a flow diagram of an embodiment of a method of producing an electronic device including a routable heat spreader coupled to one or more sensor packages, in accordance with some embodiments of the present disclosure.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

In one or more embodiments, a semiconductor packaging structure may include a routable heat spreader (RHS) configured to provide heat dissipation functionality and configured to provide one or more electrical terminals. In some embodiments, the RHS may be formed from a suitable thermally and electrically conductive material (such as copper, aluminum, gold, silver, iron, silicon carbide, graphite, graphene, or another conductive material). The RHS may be etched, stamped, plated (electrolytic or electroless plated) or cut to form gaps that may be filled with a thermally conducting and electrically insulating (dielectric) material (such as thermoset, a silicone elastomer, or another thermally conductive and electrically insulative (dielectric) material) to produce electrical terminals that may be electrically isolated from the remainder of the RHS by the insulating material. The RHS may be coupled to a semiconductor device and one or more circuits may be electrically coupled to the electrical terminals of the RHS to provide three-dimensional (3D) chip stacking with passive thermal management. In some embodiments, the resultant semiconductor package (with the RHS as a lid) may have relatively low warpage.

In some embodiments, the RHS may be implemented as a lid that may include one or more terminals for low input/output (I/O) count sensors or other circuits. The routable lid may fully isolate the sensors or other circuits from the semiconductor wafer or from a customer's printed circuit board (PCB), resulting in smaller form factor (footprint) and a 3D-stacked structure. Short interconnect lengths through the routable lid may reduce latencies in a sensing-and-acting loop that involves a processor configured to receive sensor data, determine information based on the sensor data, and send one or more control signals based on the determined information.

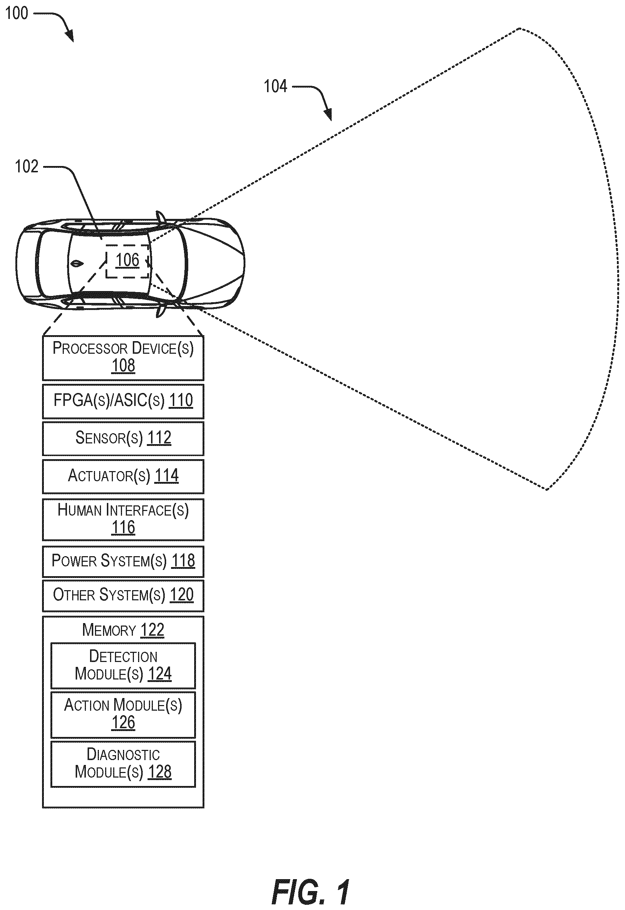

The RHS of the present disclosure may be utilized in a variety of contexts. For example, the RHS may be used in any circuit context in which it may utilize sensors to provide a reduced latency signal path from the sensors to a processing circuit. Examples of such contexts may include industrial control, industrial process monitoring, security monitoring, automotive detection and control, and so on. One possible, non-limiting example of a system including the RHS may include an automotive system with sensors to detect objects in or near a path of a vehicle, such as that described below with respect to FIG. 1.

FIG. 1 depicts a diagram of a system 100 including a semiconductor device 106 that has a routable heat spreader, in accordance with some embodiments of the present disclosure. The system 100 may include a vehicle 102 that includes the semiconductor device 106 as part of its internal systems. In this example, the semiconductor device 106 may include one or more sensors 112 configured to determine objects in a coverage area (generally indicated at 104) in front of the vehicle 102 (as shown), objects behind the vehicle 102 in a coverage area (not shown), or any combination thereof. The one or more sensors 112 may include optical sensors (e.g., cameras, reflected-light sensors, other sensors, or any combination thereof), radio frequency (RF) sensors (e.g., radar, millimeter waveform sensors, other RF sensors, or any combination thereof), acoustic sensors, other sensors, or any combination thereof.

The semiconductor device 106 may include one or more processor devices 108, which may be configured to execute processor-readable instructions and to process data from the one or more sensors 112. In some embodiments, the semiconductor device 106 may include one or more field programmable gate arrays (FPGAs) or application specific integrated circuits (ASICS) 110, which may be coupled to the one or more sensors 112 or which may be configured to receive signals or data from another source. The FPGAs/ASICs 110 may be configured or programmed to process received data according to a predetermined set of logic blocks. In some implementations, the FPGAs/ASICs 110 may perform pre-processing of received sensor data before the one or more processor devices 108 may further process the sensor data according to one or more processor-readable instructions in a memory 122.

In some embodiments, the system 100 may include one or more actuators 114, which may include braking systems, power steering, HVAC (heating, ventilation, and air-conditioning) system components (e.g., compressors, blowers, and other components), and various other components. The one or more actuators 114 may be responsive to control signals from one or more of the processor devices 108 or the FPGAs/ASICs 110 to detect objects in the coverage area 104.

The system 100 may include one or more human interfaces 116, such as a touchscreen, control buttons, a steering interface, and other control features that may be accessed by a user to interact with and optionally control operation of the vehicle 102. In some implementations, the human interfaces 116 may include window controls, entertainment controls, menu controls, and other control elements that enable user control of the vehicle 102 and its various features.

The system 100 may include one or more power systems 118, which may include one or more batteries, power generators including one or more of an alternator, a power-regenerative braking system, or other power systems. Additionally, the one or more power systems 118 may include power management circuitry and controls.

The system 100 may include other systems 120. The other systems 120 may include their own processing circuitry or may be coupled to the FPGAs/ASICs 110 or processor devices 108.

The system 100 may include the memory 122, which may be configured to store processor-readable instructions as well as data. The memory 122 may include one or more detection modules 124 that may be executed by the one or more processor devices 108 or the FPGAs/ASICs 110 to receive data from the one or more sensors 112 and to determine object data, temperature data, or other data from the received data.

The memory 122 may include one or more action modules 126 that may cause the one or more processor devices 108 or FPGAs/ASICs 110 to determine one or more actions based on the data determined by the one or more detection modules 124. The one or more action modules 126 may generate control signals based on the determined actions and may send the control signals to one or more of the one or more actuators 114 to cause the selected actuators 114 to perform an operation.

The memory 122 may include one or more diagnostic modules 128 that may process the data determined by the one or more detection modules 124 to determine diagnostic data related to one or more components of the system 100. The diagnostic modules 128 may provide diagnostic data to the action modules 126, which may send control signals to selected ones of the one or more actuators 114 based on the diagnostic data.

In one or more embodiments, the semiconductor device 106 may include a routable heat spreader (RHS) that may be configured to couple the one or more sensors 112 to the one or more processor devices 108. The RHS may provide heat dissipation for the one or more processor devices 108 while enabling electrical connections to the one or more processor devices 108. In particular, the RHS may include one or more electrically conductive terminals that may electrically connect at least one of the one or more sensors 112 to the one or more processor devices 108. The RHS may fully isolate the sensor 112 from the printed circuit board (PCB) and enable a reduced form factor (reduced footprint) by allowing three-dimensional stacking of the sensor 112 and the processor device 108. Additionally, the RHS enables a short interconnect length between the sensor 112 and the processor device 108, reducing latency in the sensor 112, processor device 108, and actuator 114 loop.

It should be understood that the automotive system 100 is just one possible embodiment of a system in which the RHS can be utilized. The RHS may be utilized in a variety of systems to provide reduced physical separation between the processor(s) and other components and reduced latency in terms of data delays.

Unlike conventional systems in which the sensor and processor packages are mounted separately which introduces delays in data transfer due to physical separation between the processor package and the different sensing components (e.g., camera, gyroscope, and so on), the RHS enables a three-dimensional stacked circuit package that shortens the data path while dissipating heat. The RHS provides heat dissipation and electrically conducting terminal functionality while demonstrating low package warpage during assembly and surface mount on printed circuit board process.

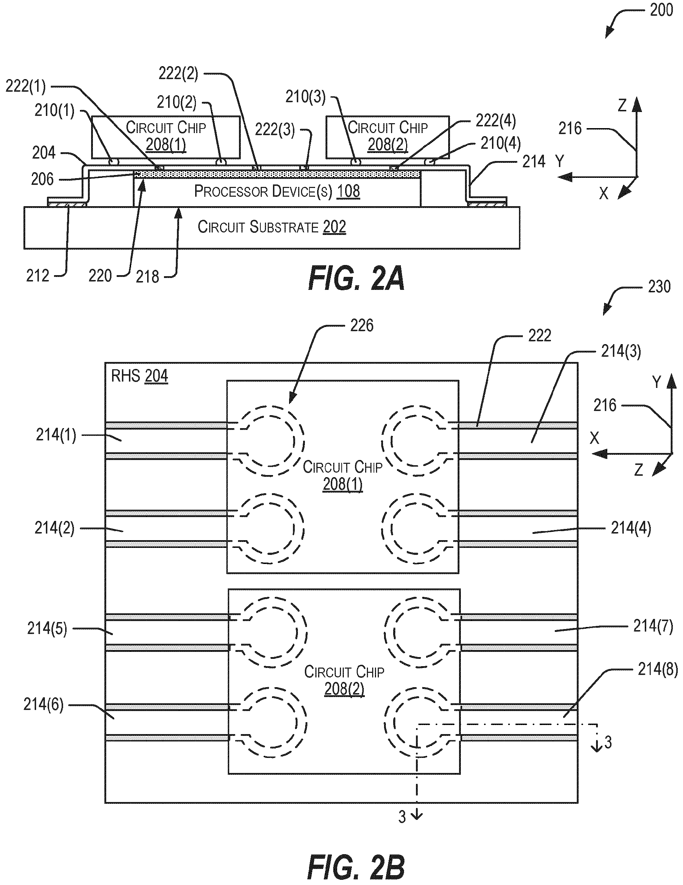

In one or more embodiments, the RHS may be configured to couple multiple sensing devices (or other circuit chips) to a processor device, such as the one or more processor devices 108. In some embodiments, the RHS may enable electrical routing using electrically conducting terminals for low input/output (I/O) count sensors. In some embodiments, the RHS may maintain isolation between the sensor and a customer's printed circuit board (PCB), resulting in a smaller form factor due to the three-dimensional stacking of the circuits. An example of an electronic device including a routable heat spreader (RHS) is described below with respect to FIG. 2A.

FIG. 2A depicts a side view of a semiconductor device 200 including a routable heat spreader 204, in accordance with some embodiments of the present disclosure. In this example, the semiconductor device 200 may include a circuit (semiconductor) substrate 202, which may be an example of a portion of the semiconductor device 106 of FIG. 1. The circuit substrate 202 may include a semiconductor substrate including a build-up portion forming multiple layers of metal and dielectric formed thereon to form various circuit structures and interconnects (not shown). The semiconductor device 200 may include one or more processor devices 108, which may be coupled to an active surface 218 of the circuit substrate 202 by one or more electrical and mechanical connections (not shown).

In some embodiments, the semiconductor device 200 may include one or more processor devices 108. Each processor device 108 has an active surface 218 and a second surface 220. The one or more processor devices 108 may be coupled to metal contact terminals on the circuit substrate 202 on the active surface 218 by one or more solder interconnects. The semiconductor device 200 may include a routable heat spreader (RHS) 204 that may extend over the second surface 220 of the one or more processor devices 108 and optionally around the one or more processor devices 108 to form a lid or cover. The RHS 204 may be configured to conduct heat away from the one or more processors 108.

The semiconductor device 200 may be coupled to the second side 220 of the one or more processor devices 108 by a thermal interface material (TIM) 206. The TIM 206 may include one or more of a thermal adhesive, a thermal gap filler (e.g., a gel, a paste, or another compound), a phase change material, a thermal tape, thermal pads, other thermal interface materials, or any combination thereof. The TIM 206 may be configured to facilitate heat transfer between the one or more processor devices 108 and the RHS 204.

The RHS 204 may be formed from a conductive material configured to dissipate heat. The RHS 204 may be etched, grooved, or cut to form "cut throughs" that may be filled with thermally conducting and electrically insulating material (thermally conducting dielectric material) 222 to provide electrically isolated terminals that can be coupled to one or more circuit chips 208, for example, by solder interconnects 210. In the illustrated embodiments, the circuit chip 208(1) is depicted as being supported by two solder interconnects 210(1) and 210(2) and circuit chip 208(2) is depicted as being supported by solder interconnects 210(3) and 210(4); however, the circuit chips 208(1) and 208(2) may be supported by any number of solder interconnects 210.

In some embodiments, the circuit chips 208 may include a sensor 112, an actuator 114, other circuits, or any combination thereof, which may be configured to generate data and to communicate data to the processor device 106. In the illustrated example, the RHS 204 may be divided into five terminals 214 by the thermally conducting and electrically insulating material (thermally conducting dielectric material) 222. The RHS 204 may be subdivided into any number of electrically isolated contact areas, each of which may be electrically and mechanically coupled to the circuit chip 208 by through silicon vias, solder bumps, wires or straps, terminals 214, or any combination thereof to enable transfer of power to the circuit chip 208 and transfer of data from the circuit chip 208 to the processor device 108.

The terminals of the RHS 204 may be electrically isolated from one another by thermally conducting and electrically insulating material (thermally conducting dielectric material) 222, such as thermoset, a silicon elastomer, or another material that provides thermal conduction and electrical isolation. The RHS 204 may be formed from a thermally conductive and electrically conductive material, such as copper, aluminum, gold, silver, iron, graphite, graphene, another conductive material, or any combination thereof.

In this example, the RHS 204 may be coupled to a first circuit chip 208(1) and a second circuit chip 208(2). The circuit substrate 202, the one or more processor devices 108, the TIM 206, the RHS 204, and the circuit chips 208 are stacked in a Z-direction, as indicated by the X-Y-Z axis 216. It should be appreciated that the circuit chips 208 may be coupled to the RHS 204 by one or more electrical connections, such as solder interconnects 210, and may be supported by dielectric material, such as an epoxy or other material that may be deposited or that may flow between the circuit chip 208 and the RHS 204 as part of the packaging process. The resulting semiconductor device 200 may be a multi-chip module (MCM) with one or more conductor terminals or pins that may be coupled to a unifying substrate, such as a customer's printed circuit board (PCB).

The RHS 204 may be communicatively coupled to the circuit substrate 202. In some embodiments, the RHS 204 may include one or more terminals 214 that may be coupled to one or more conductive pads 212 formed on or within a layer of the circuit substrate 202. The terminal 214 may conduct signals (communicate data) between an associated circuit chip 208 and the circuit substrate 202, which may route the signals (communicated data) to and from the one or more processor devices 108.

It should be understood that the RHS 204 is routable such that the RHS 204 may provide multiple electrically-isolated terminals that can be coupled to conductive terminals or contact terminals of the circuit substrate (semiconductor substrate) 202. In the illustrated example, the circuit chip 208(1) may be coupled to the RHS 204 and may be electrically isolated from the circuit chip 208(2), which may be coupled to a different terminal of the RHS 204. To illustrate how the RHS 204 may provide electrically isolated terminals, an illustrative embodiment of a routed heat spreader 204 is shown and described with respect to FIG. 2B.

FIG. 2B depicts a top view 230 of an embodiment of the semiconductor device 200 of FIG. 2A. The top view 230 depicts the RHS 204 with the circuit chips 208 mounted thereon. The RHS 204 includes terminals 214. Each terminal 214 is cut out, etched, or stamped from the heat spreader material and the gaps may be filled with the thermally conductive and electrically-insulative material 222, such as thermoset, a silicon elastomer, or another material that provides thermal conduction and electrical isolation. The electrically-insulative material 222 may isolate each of the terminals 214 to enable electrical routing.

In this example, the circuit chip 208(1) may be coupled to one or more of a first terminal 214(1), a second terminal 214(2), a third terminal 214(3), and a fourth terminal 214(4), each of which may be electrically isolated from one another and from the rest of the conductive material of the RHS 204 by the thermally conductive and electrically-insulative material 222. The circuit chip 208(2) may be coupled to one or more of a fifth terminal 214(5), a sixth terminal 214(6), a seventh terminal 214(7), and an eighth terminal 214(8), each of which may be electrically isolated from one another and from the rest of the conductive material of the RHS 204 by the thermally conductive and electrically-insulative material 222.

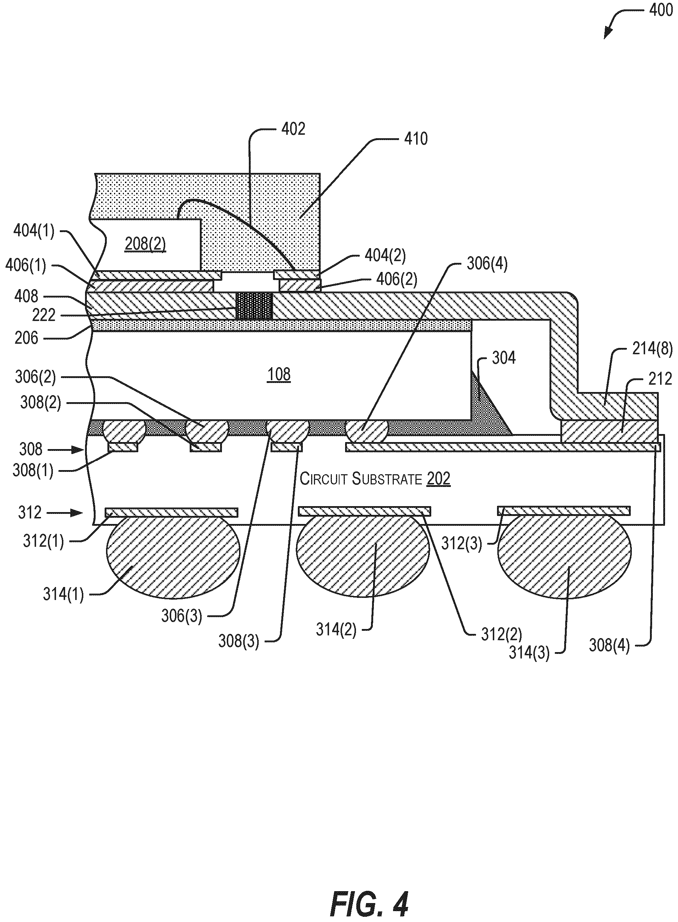

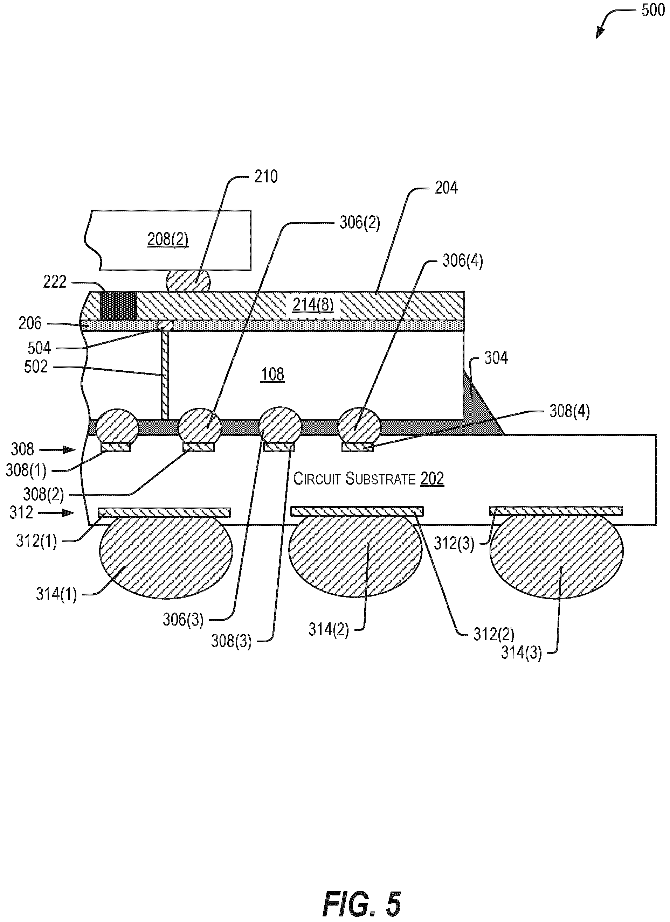

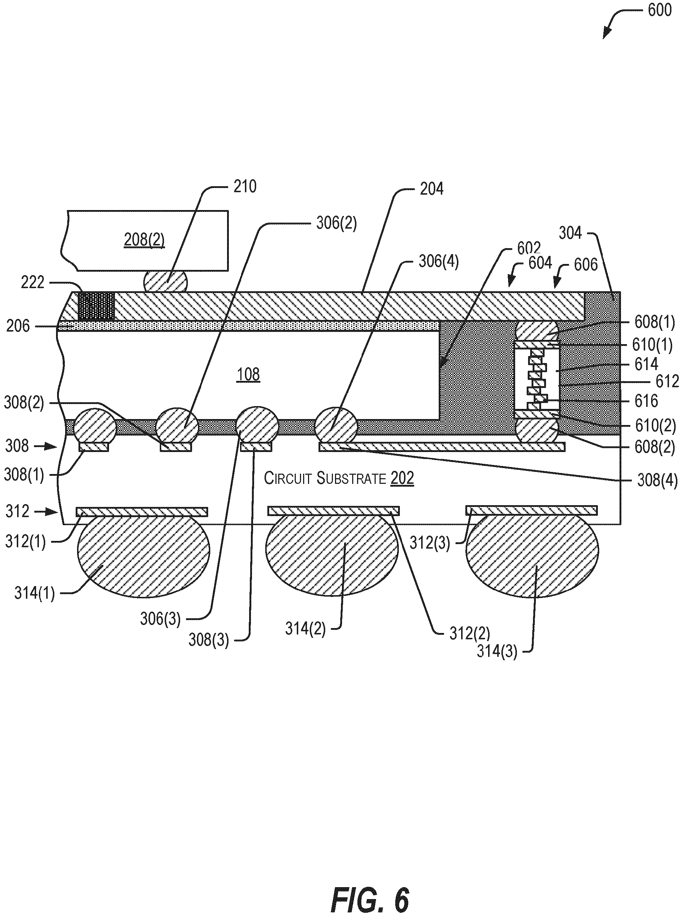

In the illustrative example, each terminal 214 includes a circular portion 226, which is shown in phantom because it is beneath the circuit chip 208. The circular portion 226 may facilitate a solder interconnect-type connection with circuit chip 208; however, the circular portion 226 could be implemented with other shapes, such as a rectangular shape, an octagonal shape, or another shape. While the illustrated embodiment of the RHS 204 includes eight terminals 214, other embodiments may include more or fewer terminals 214. Additionally, while the terminals 214 are depicted as extending to the edges of the RHS 208, in other embodiments, isolated terminals 214 may be provided that are electrically isolated from other terminals 214 and isolated from the edges of the RHS 204. Such isolated terminals may be coupled to the processor device 108 by a solder interconnect and a wire (such as that shown in FIG. 4), through silicon via (such as that shown in FIG. 5), through a solder interconnect to a contact pad on the processor device 108, through an interposer (such as that shown in FIG. 6), by another electrical interconnection, or any combination thereof.

In some embodiments, the RHS 204 may be coupled to the one or more processor devices 108 and to the circuit substrate 202, and one or more of the terminals 214 may be electrically coupled to conductive pads or terminals on or within a surface of the circuit substrate 202. The terminals 214 may form an electrical connection between one of the circuit chips 208 and circuitry associated with the circuit substrate 202.

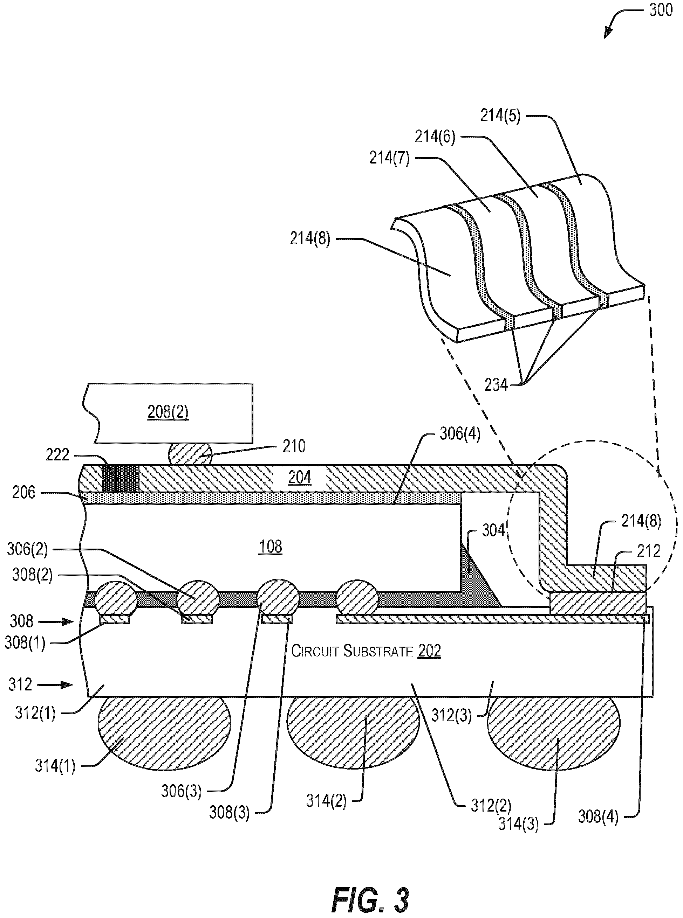

In the following discussion of FIGs. 3-6, several cross-sectional views of the semiconductor device of 200 of FIG. 2B are shown that include variations with respect to electrical interconnections between the circuit chip 208 and the circuit substrate 202. An example of an embodiment in which the RHS 204 includes a conductive terminal 214 that is coupled to a conductive pad 212 on or within the substrate 202.

FIG. 3 depicts a cross-sectional view 300 of an embodiment of a semiconductor device 200 taken along line 3-3 in FIG. 2B and including a circuit chip 208 coupled to a terminal 214(8) of the routable heat spreader 204, in accordance with some embodiments of the present disclosure. In the illustrated example, the circuit substrate 202 may include a build-up portion formed of multiple metal layers, such as metal layers 308 and 312, and multiple dielectric layers (not shown). In this example, only two metal layers 308 and 312 are shown, but it should be appreciated that the circuit substrate 202 may include any number of metal layers 308 and 312, dielectric layers, and interconnects between the metal layers. The metal layer 312 may include exposed contact terminals 312(1), 312(2), and 312(3), which may electrically and mechanically couple to solder interconnects 314(1), 314(2), and 314(3), respectively, to couple the circuit substrate 202 to a unifying structure, such as a customer's printed circuit board (PCB) (not shown).

The metal layer 308 may include exposed contact terminals 308(1), 308(2), 308(3), and 308(4), which may be coupled to the processor device 108 by solder interconnects 306(1), 306(2), 306(3), and 306(4). In some embodiments, the solder interconnects 306, the top surface of the circuit substrate 202, and the bottom surface of the processor device 108 may be sealed by an encapsulant 304, such as one or more of epoxy, silicone, polyurethane, phenolic, other molding compounds, or any combination thereof.

In this example, the circuit chip 208 may be coupled to a terminal 214(8) of the RHS 204 by a solder interconnect 210. The terminal 214(8) may be electrically isolated from the remaining RHS 204 and from other terminals 214 by an electrically-insulative material 222. In some embodiments, the electrically-insulative material 222 may be thermally conductive dielectric material, such as a thermoplastic, a synthetic resin, thermoset, a silicon elastomer, or another material that provides thermal conduction and electrical isolation.

The terminal 214(8) may bend toward the circuit substrate 202 and may be coupled to a contact terminal 212, which may be coupled to the contact terminal 308(4) within or on the circuit substrate 202. The contact terminal 308(4) may couple the terminal 214(8) to the processor device 108 through the solder interconnect 306(4).

A portion of the RHS 204 is shown that includes multiple terminals 214 separated from one another by the electrically-insulative material 222. In this example, the RHS 204 includes four conductors that can provide electrical routing for different circuit chips 208 or for different terminals of a circuit chip 208.

The RHS 204 may be configured to couple multiple circuit chips 208 to a processor device 108. The circuit chips 208 may include sensors or other circuits. In one or more embodiments, the RHS 204 may enable electrical routing sensors. In one or more embodiments, the sensors may include low input/output count sensors. The RHS 204 may couple to the circuit chip 208, which may be isolated from the customer PCB resulting in a smaller form factor (footprint) than if the circuit chip 208 were mounted directly onto the PCB.

The RHS 204 may enable relatively short interconnects, reducing latency in a sensing/acting loop that involves the processor device 108. In some implementations, the RHS 204 may enable the processor device 108 and one or more circuit chips 208 to be packaged as a multi-chip module. Alternatively, the processor device 108 with the RHS 204 may be shipped separately from the circuit chip 208, which may be mounted on the customer PCB in one reflow process. The RHS 204 enables three-dimensional (3D) stacking of the processor device 108 and the circuit chip 208. Additionally, the metal of the RHS 204 may provide low package-on-package (PoP) warpage.

While the example of FIG. 3 depicts a circuit chip 208 coupled to the RHS 204 by a solder interconnect 210, in some embodiments, in addition or in lieu of the solder interconnect 210, the circuit chip 208 may be coupled to a first terminal 214 of the RHS 204 by a first conductor and to a second terminal 214(8) of the RHS 204 by a strap, wire, or other interconnect. An example of an embodiment of a 3D stacked multi-chip module with a strap is shown and described with respect to FIG. 4.

FIG. 4 depicts a cross-sectional view of another embodiment of a semiconductor device 400 taken along line 3-3 in FIG. 2B and including a circuit chip 208 coupled to a terminal 214 of a RHS 204, in accordance with some embodiments of the present disclosure. The semiconductor device 400 may include all the elements of the semiconductor device 200 of FIG. 3 except that the circuit chip 208(2) is coupled to the RHS 204 at a different position relative to the electrically-insulative material 222 as compared to the embodiment shown in FIG. 3. In this example, the circuit chip 208(2) may be coupled to a terminal 408 of the RHS 204 by solder paste 406(1) and a lead 404(1).

The circuit chip 208(2) may be coupled to the terminal 214(8) by a strap (wire, jumper, interconnect, or other conductive element) 402, which may be coupled to a lead 404(2), which may be coupled to the terminal 214(8) by solder paste 406(2).. In this example, the lead 404 and the solder paste 406 may electrically couple the circuit chip 208(2) through the strap 402 to the terminal 214(8) of the RHS 204. The strap 402, the circuit chip 208(2) and the leads 404 may be covered by a mold compound 410, which may seal the leads 404 and the strap 402 from the environment.

In the examples of FIGs. 3 and 4, the terminal 214(8) is shown to couple the circuit chip 208(2) to the processor device 108 through the metal layer 308(4) within or on the circuit substrate 202. However, other interconnections are also possible. In some embodiments, the terminal 214(8) may be coupled to the circuit substrate 202 by a through-silicon via (TSV). An example of such an embodiment is described below with respect to FIG. 5.

FIG. 5 depicts a cross-sectional view of another embodiment of a semiconductor device 500 taken along line 3-3 in FIG. 2B and including a circuit chip 208(2) coupled to a terminal 214(8) of the RHS 204 and including a through silicon via (TSV) 502, in accordance with some embodiments of the present disclosure. The semiconductor device 500 includes all the elements of the semiconductor device 200 in FIG. 3, except that the terminal 214(8) of the RHS 204 does not curve toward the circuit substrate 202 and does not couple to the metal layer 308(4) through a contact terminal 212. Instead, the RHS 204 is shown as being planar and connects to the one or more processor devices 108 through the TSV 502, which is coupled to the RHS 204 by a solder interconnect 504. The TSV 502 may extend through the silicon of the one or more processor devices 108 and may couple to a metal layer or conductive trace at or near an active surface of the one or more processor devices 108.

In the illustrated example, only a single TSV 502 is depicted as extending from the terminal 214(8) of the RHS 204 to the active surface of the processor device 108. However, it should be understood that the one or more processor devices 108 may include a plurality of TSVs 502, which may couple to different terminals 214 of the RHS 204.

In another example, the RHS 204 may be coupled to the metal layer 308 of the circuit substrate 202 using an interposer or interconnect. An embodiment that uses such as interconnect is described below with respect to FIG. 6.

FIG. 6 depicts a cross-sectional view of another embodiment of a semiconductor device 600 taken along line 3-3 in FIG. 2B and including a circuit chip 208 coupled to a terminal 214(8) of the RHS 204 and including a conductive interposer, in accordance with some embodiments of the present disclosure. In this example, the semiconductor device 600 may include all the elements of the semiconductor device 200 of FIG. 3, except that the terminal 214(8) of the RHS 204 does not curve toward the circuit substrate 202 and does not couple to the metal layer 308(4) through a contact terminal 212. Instead, the terminal 214(8) of the RHS 204 extends past a peripheral edge 602 of the processor device 108 to provide an overhanging portion, generally indicated at 604.

The overhanging portion 604 of the terminal 214(8) may be coupled to a metal layer 308 of the circuit substrate 202 by a conductive interconnect, generally indicated at 606. The conductive interconnect 606 may be formed from one or more conductive elements that extend between and electrically couple the overhanging portion 604 of the terminal 214(8) and an exposed contact terminal 308(4) within or on the circuit substrate 202.

In some embodiments, the interconnect 606 may include a solder interconnect 608(1) coupled to the terminal 214(8) of the RHS 204. The solder interconnect 608(1) may be coupled to an interposer 612, which may include a substrate material 614 surrounding a one or more conductive metal layers (or a conductive via) 616. The interposer 612 may include a metal contact layer 610(1) coupled to the one or more metal layers 616 and configured to couple the one or more conductive layers 616 to the solder interconnect 608(1). The interposer 612 may be electrically coupled to the terminal 214(8) through the solder layer 610(1) and the solder interconnect 608(1). The interposer 612 may be coupled to the circuit substrate 202 through a solder layer 610(2) and a solder interconnect 608(2), which may be coupled to the contact terminal 308(4) of the metal layer 308.

In the illustrated example, the interconnect 606 may form the electrical connection and then may be surrounded by the encapsulant 304. The circuit chip 208(2) may be coupled to the processor device 108 through the terminal 214(8), the interconnect 606, and the contact terminal 308(4).

In general, the RHS 204 may enable various types of interconnections (bent terminal 214 coupled to a contact terminal 308(4), a strap 402, a TSV 502, an interconnect 606, other electrical interconnections, or any combination thereof. The versatility of the RHS 204 may allow for short interconnect lengths to couple sensors or other circuit chips 208 to the processor device 108 through the RHS 204. The RHS 204 allows for stacking of the processor device 108 with other circuit chips 208, reducing the form factor and conserving real estate on the customer's printed circuit board or on the underlying circuit substrate 202. In some embodiments, the RHS 204 may be used to couple multiple sensors or circuit chips 208 to the processor device 108.

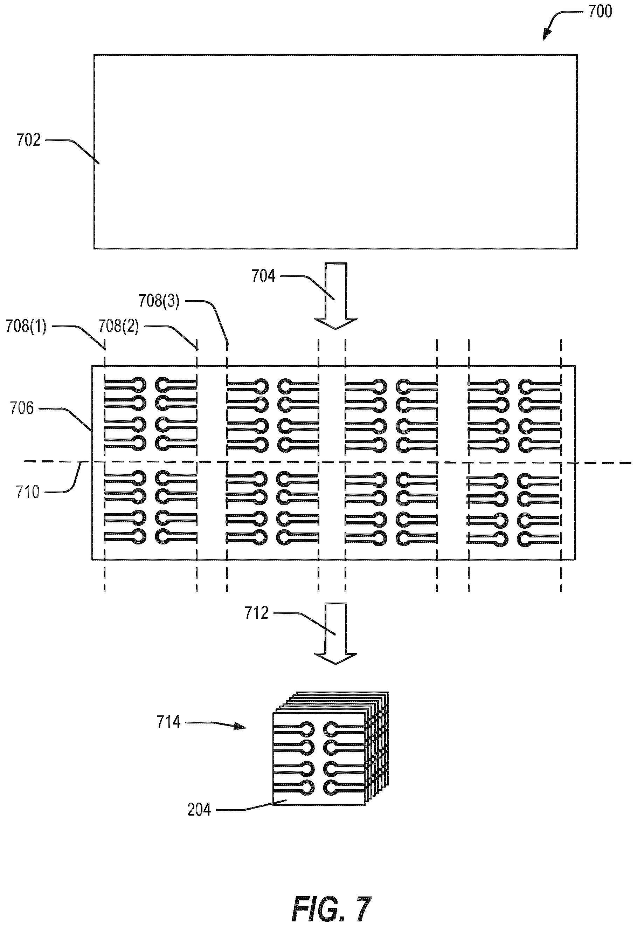

FIG. 7 depicts a flow diagram of an embodiment of a method 700 of forming a plurality of routable heat spreaders, in accordance with some embodiments of the present disclosure. The method 700 may include selecting a lid or routable heat spreader material 702. In the illustrated example, the lid or routable heat spreader (RHS) material 702 may be a sheet of conductive material, such as copper, aluminum, gold, silver, iron, graphite, or another conductive material.

At 704, the selected material 702 may be etched, cut, or stamped to form gaps that can be filled with heat-conducting and electrically-insulative material 222 to form a material substrate with routing 706. The electrically-insulative material 222 that fills the gaps may include thermoset, a silicon elastomer, or another material that provides thermal conduction and electrical isolation. In the illustrated example, the material 702 is stamped and filled to form eight routable heat spreaders (RHS 204) that are separated by a scribe lane and that include terminals 214 that are aligned toward two edges. In other embodiments, the terminals 214 may be aligned toward one or more of the edges. In one or more embodiments, the terminals 214 may be aligned toward all four edges.

It should be noted that the stamped and filled shapes are isolated from the material 702 along their sides; however, the ends of the shapes are still attached to the material 702. The cut lines along which the material may be cut to singulate the RHS 204 are shown as dashed lines 708 and 710.

At 712, the substrate with routing 706 is cut along the cut lines 708 and 710 to form a plurality of routable heat spreaders (RHSs) 204, which are shown in a stack 714. Each RHS 204 may be used to couple a circuit chip 208 to one or more of a circuit substrate 202, a processor device 108, or other circuitry.

In some embodiments, the substrate with routing 706 may be trimmed along the cut lines 708 and 710 and then the edges may be bent to form gull wing lead shapes. The lead tips of the terminals 214 may be placed inside of a (trim and form machine) to achieve a selected shape (where the trim and form operations are performed after the molding process).

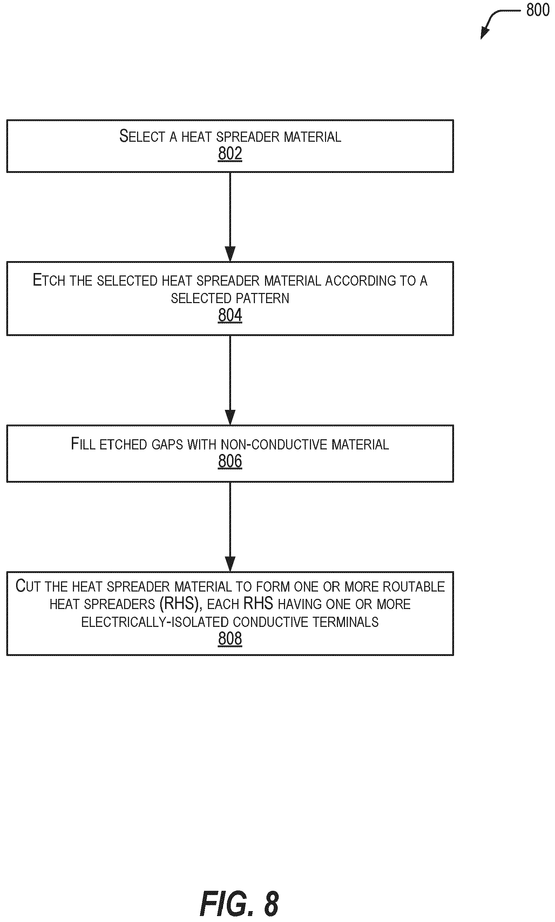

FIG. 8 depicts a flow diagram of an embodiment of a method 800 of forming a plurality of routable heat spreaders 204, in accordance with some embodiments of the present disclosure. At 802, the method 800 may include selecting a heat spreader material 702. The heat spreader material 702 may include copper, aluminum, gold, silver, iron, silicon carbide, graphite, graphene, other thermally and electrically conductive material, or any combination thereof.

At 804, the method 800 may include etching or cutting or stamping the selected heat spreader material 702 according to a selected pattern. The selected pattern may be created by removing material in selected areas to produce shapes that are disconnected from the surrounding heat spreader material 702 on at least one side. In the illustrated example of the material substrate with routing 706 in FIG. 7, the shapes are disconnected from the surrounding heat spreader material 702 on at least three sides.

At 806, the method 800 may include filling the etched (cut or stamped or patterned) gaps with non-conductive material. In some embodiments, the non-conductive material may be formed from a heat-conducting material that has a thermal expansion coefficient that is the same as the surrounding heat spreader material 702. Alternatively, the heat-conducting and electrically insulating material may have thermal properties that may cooperate with the surrounding heat spreader material 702 to provide electrical isolation along the sides of the cutout shapes, to conduct heat similarly to the surrounding heat spreader material 702, and to expand and contract similarly to the surrounding heat spreader material 702 so that the non-conductive material does not separate from the gaps.

At 808, the method 800 may include cutting the heat spreader material 702 (the material substrate with routing 706 in FIG. 7) to form one or more routable heat spreaders (RHS) 204 where each RHS 204 has one or more electrically-isolated conductive terminals. As shown in FIG. 7, the RHSs 204 may be separated (singulated) to form individual RHSs 204. The cutting operation may trim the material substrate with routing 706 so that the shapes are isolated from the surrounding heat spreader material 702 by the non-conductive filler material, such as thermoset, a silicon elastomer, or another material that provides thermal conduction and electrical isolation. The RHSs 204 may be applied to the processor device 108 and coupled to one or more circuit chips 208 to provide a multi-chip circuit package.

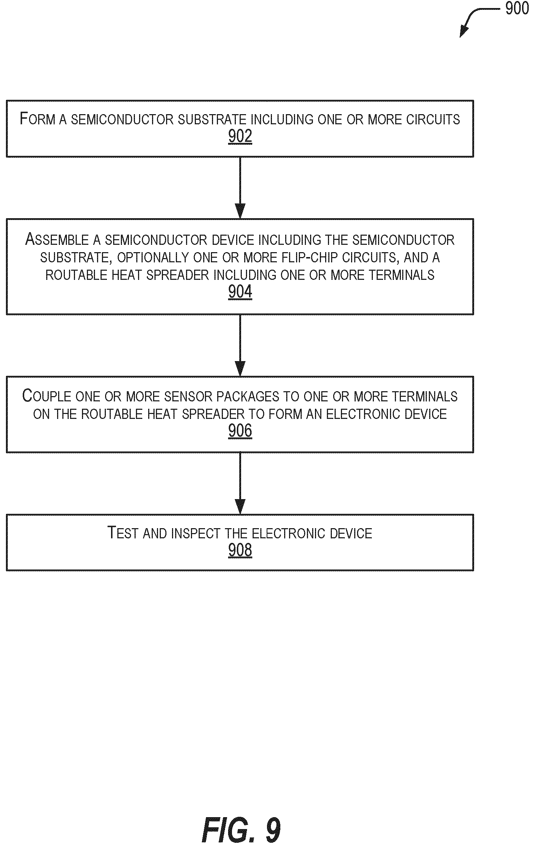

FIG. 9 depicts a flow diagram of an embodiment of a method 900 of producing an semiconductor device 200 including a routable heat spreader 204 coupled to one or more sensor packages (circuit chips 208), in accordance with some embodiments of the present disclosure. At 902, the method 900 may include forming a circuit substrate 202 including one or more circuits. The circuit substrate 202 may include substrate including a build-up portion formed from multiple layers of metal and dielectric material to form various circuit structures and electrical interconnects.

At 904, the method 900 may include assembling a semiconductor device including the semiconductor substrate (circuit substrate 202), optionally one or more flip-chip circuits (such as a processor device 108), and an RHS 204 including one or more terminals 214. The assembly process may include mechanically and electrically coupling the processor device 108 to contact terminals associated with a metal layer 308 of the circuit substrate 202.

At 906, the method 900 may include one or more sensor packages (circuit chips 208) to the one or more terminals 214 on the RHS 204 to form an electronic device (such as the electronic devices 200, 300, 400, 500, or 600 in FIGs. 2-6). It should be appreciated that sensor packages are an example of a circuit chip 208, but that other types of circuit chips 208 may be coupled to the RHS 204, depending on the implementation.

At 908, the method 900 may include testing and inspecting the electronic device. The testing process may include applying test signals, visually inspecting the device using optical sensors, other forms of testing, or any combination thereof.

In some embodiments, by utilizing the RHS 204 to couple the circuit chips 208 and the processor device 108, the RHS 204 can be used to stack the circuits, reducing the form factor of the multi-chip circuit package. In some embodiments, by utilizing the RHS 204 to route signals between circuit chips 208 and the processor device 108, the RHS 204 may reduce the length of signal paths between the one or more circuit chips 208 and the processor device 108 as compared to routing across the customer's printed circuit board (PCB). The reduced signal path length may reduce latencies in the sensor-processor-actuator loop.

In some embodiments, the RHS 204 enables the processor device 108 and sensor chips to be packaged together and shipped to a customer as a multi-chip module (multi-chip package), reducing the installation steps for the customer. In some embodiments, the RHS 204 may allow the customer to mount customer-selected circuit chips 208 to the processor device 108 that includes the RHS 204. In some embodiments, the metal of the RHS 204 may reduce package-on-package warpage because it dissipates heat and resists warping.

In one or more embodiments, a semiconductor device 200 may include a circuit substrate 202, a processor device 108, and a routable heat spreader (RHS) 204. The circuit substrate 202 may include a build-up portion formed from multiple layers. The multiple layers may include metal layers 308 and 312 separated by dielectric layers and including interconnections (not shown) between at least some of the metal layers 308 and 312. The circuit substrate 202 may include multiple contact terminals including a first contact terminal 308(1) and one or more second contact terminals 308(4). The processor device 108 may include a first side 218 and a second side 220. The processor device 108 may be coupled to the first contact terminal 308(1) on the first side 218. The RHS 204 may be formed from a thermally conductive and electrically conductive material and may extend over the second side of the processor device. The RHS 204 may include one or more conductive terminals 214. Each conductive terminal 214 may be electrically isolated from a remainder of the RHS 204 and electrically coupled to one of the one or more second contact terminals 308(4).

In some embodiments, the RHS 204 may be formed from a thermally conductive and electrically conductive material, such as copper, aluminum, gold, silver, iron, silicon carbide, graphite, graphene, another conductive material, or any combination thereof. In one or more embodiments, each conductive terminal 214 is separated from surrounding material of the RHS 204 and from others of the one or more conductive terminals 214 by a thermally conductive electrically-insulative material 222. In some embodiments, the thermally conductive electrically-insulative (dielectric) material 222 may include thermoset, a silicon elastomer, or another material that provides thermal conduction and electrical isolation.

In some embodiments, the semiconductor device 200 may include a thermal interface material (TIM) 206 between the second side 220 of the processor device 108 and the RHS 204. The semiconductor device 200 may include a circuit chip 208 coupled to a first terminal 214 of the one or more conductive terminals 214 of the RHS 204. The circuit chip 208 may be configured to communicate data to the processor device 108 through the first terminal 214 of the one or more conductive terminals. The circuit substrate 202 may include a signal path from one of the one or more second contact terminals 212 to the first contact terminal 308(1).

In some embodiments, the circuit device 208 may include a circuit chip that is coupled to a first terminal 214(1) of the one or more conductive terminals 214 and that is electrically coupled by an interconnect 402 to a second terminal 214(2) of the one or more conductive terminals 214. One or more of the first terminal 214(1) and the second terminal 214(2) may be communicatively coupled to the circuit substrate 202.

In some embodiments, the semiconductor device 500 may include a through silicon via (TSV) extending from a first terminal of the one or more conductive terminals of the RHS 204 to the circuit substrate 202 to provide a signal path. The semiconductor device 500 may include a circuit chip 208 coupled to the first terminal 214(8) the one or more conductive terminals 214.

In some embodiments, the RHS 204 may include a first terminal 214(8) of the one or more conductive terminals 214 that extends beyond a peripheral edge 602 of the processor device 108 to form an overhanging portion 604. The semiconductor device may include an interconnect 606 formed from one or more conductive materials and extending between the overhanging portion 604 and one of the one or more second contact terminals 308(4) of the circuit substrate 202. In some embodiments, an encapsulant 304 around the interconnect 606 and between the interconnect 606 and the processor device 108.

In some embodiments, the one or more conductive terminals of the RHS 204 may include a first terminal 214(1) and a second terminal 214(2), and the one or more second contact terminals 308 of the semiconductor substrate may include a first contact terminal 308(4) and a second contact terminal 308(N). The first contact terminal 308(4) may be coupled to a first signal path through the circuit substrate 202 to the processor device 108, and the second contact terminal 308(N) may be coupled to a second signal path through the circuit substrate 202 to the processor device 108. The first terminal 214(1) may be coupled to the first contact terminal 308(4) of the one or more second contact terminals, and the second terminal may be coupled to the second contact terminal 308(N) of the one or more second contact terminals. The semiconductor device 200 may include a first circuit 208(1) coupled to the first terminal 214(8) of the RHS 204 and a second circuit 208(2) coupled to the second terminal 214(7) of the RHS 204.

In one or more embodiments, a method 900 of forming a semiconductor device may include forming a circuit substrate 202 including one or more circuits and assembling a semiconductor device 200 including the circuit substrate 202, a processor device 108 coupled to the circuit substrate 202, and a routable heat spreader (RHS) 204 coupled to the processor device 108. The RHS 204 may include one or more conductive terminals 214 coupled to the circuit substrate 202. The method 900 may include coupling a circuit chip 208 to a first terminal 214(8) of the one or more conductive terminals 214 to form an electronic device.

In one or more embodiments, prior to assembling the semiconductor device, the method 800 may include selecting a heat spreader material 702 that is thermally conductive and electrically conductive. In some embodiments, the heat spreader material 702 may include copper, aluminum, gold, silver, iron, silicon carbide, graphite, graphene, another conductive material, or any combination thereof. The method 800 may include etching the selected heat spreader material 702 according to a selected pattern, at 804. More generally, the method 800 may include selectively removing portions of the heat spreader material 702 to form gaps defining one or more shapes and filling the gaps with a thermally conductive and electrically-insulative material, at 806. In some embodiments, the thermally conductive and electrically-insulative material 222 may include one or more of thermoset, a silicone elastomer, or another thermally conductive and electrically insulative material. The method 800 may include cutting the heat spreader material 702 to form the RHS 204 including the one or more conductive terminals 214. Each conductive terminal 214 may be electrically isolated from a remainder of the heat spreader material 702 and from others of the one or more conductive terminals 214 by the electrically-insulative material 222.

In some embodiments, the method may include forming an electrical connection between one of the one or more conductive terminals 214 of the RHS 204 and a contact terminal 308(4) associated with the circuit substrate 202 to couple the circuit chip 208 to at least one of the processor devices 108 and the one or more circuits of the circuit substrate 202. In some embodiments, forming the electrical connection may include forming a through-silicon-via (TSV) 502 extending through one or more of the processor device 108 or layers of the circuit substrate 202 and coupling the RHS 204 to the TSV 502.

In some embodiments, the RHS 204 may include an overhanging portion 604 that extends beyond an edge 602 of the processor device 108. Forming the electrical connection may include coupling an interconnect 606 (e.g., a conductive interposer) between an overhang portion 604 of the RHS 204 and the contact terminal 308(4).

In some embodiments, the one or more conductive terminals 214 may include a first terminal 214(A) and a second terminal 214(B). The circuit substrate may include a first contact terminal 308(A) coupled to the first terminal 214(A) and a second contact terminal 308(A) coupled to the second terminal 214(B).

In some embodiments, assembling the semiconductor device 400 may include coupling a circuit chip 208 to the RHS 402 and coupling an interconnect 402 from the first terminal 214(8) to the circuit chip 208. In some embodiments, assembling the semiconductor device 200 may include coupling a first circuit 208(1) to the first terminal 214(1) and coupling a second circuit 208(2) to the second terminal 214(5).

In some embodiments, a semiconductor device 200 may include a circuit substrate 202, a processor device 108, a circuit chip 208, and a RHS 204. The circuit substrate 202 may include a build-up portion formed from multiple layers including metal layers 308 and 312 separated by dielectric layers (not shown) and including interconnections (not shown) between at least some of the metal layers. The circuit substrate 202 may include multiple contact terminals including a first contact terminal 308(1) and one or more second contact terminals 308(4). The processor device 108 may include a first side 218 and a second side 220. The processor device 108 may be coupled to the first contact terminal 308(1) on the first side 218. The circuit chip may be configured to generate data. The RHS may be coupled to the second side 220 of the processor device 108. The RHS 204 may include one or more conductive terminals 214 including a first terminal 214(8) coupled to the circuit chip 208. Each conductive terminal 214 is electrically isolated from a remainder of the RHS 204 and from others of the conductive terminals 214 and is electrically coupled to one of the one or more second contact terminals 308(4) to communicate the data from the circuit chip 208 to the processor device 108 through at least one metal layer 308 of the circuit substrate 202.

In some embodiments, each conductive terminal 214 is separated from surrounding material of the RHS 204 and from others of the one or more conductive terminals 214 by a thermally conducting electrically-insulative material (thermally conducting dielectric material) 222. The semiconductor device 300, 400, 500, or 600 may include an interconnect 212, 402, 502 (TSV 502), or 606 configured to couple the first terminal 214(8) to one of the circuit chip 208 or the circuit substrate 202.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor device comprises:
a circuit substrate including a build-up portion formed from multiple layers, the multiple layers including metal layers separated by dielectric layers and including interconnections between at least some of the metal layers, the circuit substrate including multiple contact terminals including a first contact terminal and one or more second contact terminals;
a processor device including a first side and a second side, the processor device coupled to the first contact terminal on the first side; and
a routable heat spreader (RHS) formed from a thermally conductive and electrically conductive material and extending over the second side of the processor device, the RHS including one or more conductive terminals, each conductive terminal is electrically isolated from a remainder of the RHS and is electrically coupled to one of the one or more second contact terminals.

2. The semiconductor device of claim 1, wherein each conductive terminal is separated from surrounding material of the RHS and from others of the one or more conductive terminals by a thermally conducting dielectric material.

3. The semiconductor device of claim 1 or claim 2, further comprising a thermal interface material between the second side of the processor device and the RHS.

4. The semiconductor device according to any preceding claim, further comprises:
a circuit chip coupled to a first terminal of the one or more conductive terminals of the RHS and configured to communicate data to the processor device through the first terminal of the one or more conductive terminals; and
wherein the circuit substrate includes a signal path from one of the one or more second contact terminals to the first contact terminal.

5. The semiconductor device according to any preceding claim, further comprising:
a circuit chip coupled to a first terminal of the one or more conductive terminals and electrically coupled by an interconnect to a second terminal of the one or more conductive terminals; and
wherein one or more of the first terminal and the second terminal is coupled to the circuit substrate.

6. The semiconductor device according to any preceding claim, further comprising:
a through silicon via (TSV) extending from a first terminal of the one or more conductive terminals of the RHS to the circuit substrate to provide a signal path; and
a circuit chip coupled to the first terminal the one or more conductive terminals.

7. The semiconductor device according to any preceding claim, wherein a first terminal of the one or more conductive terminals extends beyond a peripheral edge of the processor device to form an overhanging portion, the semiconductor device further comprising:
an interconnect formed from one or more conductive materials and extending between the overhanging portion and one of the one or more second contact terminals of the circuit substrate; and
an encapsulant around the interconnect and between the interconnect and the processor device.

8. The semiconductor device according to any preceding claim, wherein the RHS is formed from one or more of copper, aluminum, gold, silver, iron, graphite, graphene, or silicon carbide.

9. The semiconductor device according to any preceding claim, wherein:
the one or more conductive terminals of the RHS includes a first terminal and a second terminal;
the one or more second contact terminals of the circuit substrate includes a first contact terminal and a second contact terminal, the first contact terminal coupled to a first signal path through the circuit substrate to the processor device, the second contact terminal coupled to a second signal path through the circuit substrate to the processor device;
the first terminal is coupled to the first contact terminal of the one or more second contact terminals;
the second terminal is coupled to the second contact terminal of the one or more second contact terminals;
further comprising:
a first circuit coupled to the first terminal of the RHS; and
a second circuit coupled to the second terminal of the RHS.

10. A method of forming a semiconductor device comprises:
forming a circuit substrate including one or more circuits;
assembling a semiconductor device including the circuit substrate, a processor device coupled to the circuit substrate, and a routable heat spreader (RHS) coupled to the processor device, the RHS including one or more conductive terminals coupled to the circuit substrate; and
coupling a circuit chip to a first terminal of the one or more conductive terminals to form an electronic device.

11. The method of claim 10, wherein, prior to assembling the semiconductor device, the method comprises:
selecting a heat spreader material that is thermally conductive and electrically conductive;
selectively removing portions of the heat spreader material to form gaps defining one or more shapes;
filling the gaps with a thermally conductive and electrically insulative material; and
cutting the heat spreader material to form the RHS including the one or more conductive terminals, each conductive terminal being electrically isolated from a remainder of the heat spreader material and from others of the one or more conductive terminals.

12. The method of claim 10 or claim 11, further comprising forming an electrical connection between one of the one or more conductive terminals of the RHS and a contact terminal associated with the circuit substrate to couple the circuit chip to at least one of the processor device and the one or more circuits.

13. The method of claim 12, wherein forming the electrical connection comprises:
forming a through-silicon-via (TSV) extending through one or more of the processor device or layers of the circuit substrate; and
coupling the RHS to the TSV.

14. The method of claim 12 or claim 13, wherein:
the RHS includes an overhanging portion that extends beyond an edge of the processor device; and
forming the electrical connection comprises coupling a conductive interposer between an overhang portion of the RHS and the contact terminal.

15. The method according to claims 10 to 14, wherein:
the one or more conductive terminals includes a first terminal and a second terminal; and
the circuit substrate includes a first contact terminal coupled to the first terminal and a second contact terminal coupled to the second terminal.
